# EUROPÄISCHE PATENTSCHRIFT

(11) **EP 3 096 593 B1**
(45) Veröffentlichungstag und Bekanntmachung des Hinweises auf die Patenterteilung: **23.08.2017**
(21) Anmeldenummer: 15001500.6
(22) Anmeldetag: 19.05.2015
(51) Int. Cl.: H05K 7/20, B64G 1/50, B64G 1/10

(54) **GERÄTETRÄGERTAFEL EINES SATELLITEN**
DEVICE HOLDER PANEL OF A SATELLITE
PANNEAU PORTE-OUTILS POUR UN SATELLITE

(43) Veröffentlichungstag der Anmeldung: 23.11.2016
(73) Patentinhaber: Airbus DS GmbH, 82024 Taufkirchen (DE)
(72) Erfinder: Bose, Guido, D-88090 Immenstaad (DE); Grasl, Andreas, D-83101 Rohrdorf/Thansau (DE)
(74) Vertreter: Frenkel, Matthias Alexander

(56) Entgegenhaltungen:
- EP-A2- 0 780 295
- EP-A2- 1 004 507
- WO-A1-2005/080198
- US-A1- 2014 146 475

## Beschreibung

### TECHNISCHES GEBIET

Die vorliegende Erfindung betrifft eine Geräteträgertafel eines Satelliten mit zumindest einem Elektronikkasten, der elektrische und/oder elektronische Baugruppen aufnimmt. Insbesondere betrifft die Erfindung eine Geräteträgertafel eines Satelliten mit zumindest einer Dockingstruktur zur Aufnahme von mit einer Mehrzahl von elektrische und/oder elektronische Baugruppen aufnehmenden Elektronikkästen, wobei die Elektronikkästen untereinander elektrisch verbunden oder verbindbar sind. Sie betrifft weiterhin einen Satelliten mit einer Mehrzahl derartiger Geräteträgerplatten.

### HINTERGRUND DER ERFINDUNG

Satelliten sind im Weltraum hohen thermischen Beanspruchungen ausgesetzt. Die Differenz zwischen der Temperatur auf der der Sonne zugewandten Seite und der Temperatur auf der von der Sonne abgewandten Schattenseite des Satelliten ist extrem hoch. Außerdem erzeugen die im Satelliten enthaltenen elektrischen und elektronischen Systeme Eigenwärme, die abzuführen ist. Ein an den Satelliten angepasstes Thermomanagement ist daher eine wesentliche Voraussetzung, um die Funktionsfähigkeit des Satelliten zu gewährleisten.

### STAND DER TECHNIK

Herkömmlicherweise werden für jede der mit elektrischen oder elektronischen Baugruppen ausgestatteten Geräteträgertafeln einzelne Heizer und einzelne Sensoren auf die Geräteträgertafel geklebt und durch Löten mit individuellen Anschlussdrähten versehen. Alle diese Drähte müssen als umfangreicher, komplexer Kabelbaum zumeist durch den ganzen Satelliten zu einer anderen Geräteträgertafel, der ausgelagerten Schnittstelleneinheit RIU (Remote Interface Unit), verlegt werden. Der Nachteil dieser konventionellen Vorgehensweise besteht aus einem enormen Integrations- und Test-Aufwand mit damit verbundenen hohen Kosten. Da einer Geräteträgertafel nicht nur Wärme zugeführt sondern von ihr auch Wärme abgeführt werden muss, sind auch entsprechende Kühleinrichtungen vorzusehen, die herkömmlicherweise ebenfalls individuell an jede Geräteträgertafel angepasst und mit ihr integriert werden müssen. Eine Geräteträgertafel eines Satelliten ist beispielsweise aus der Druckschrift EP 0 780 295 A2 bekannt.

### DARSTELLUNG DER ERFINDUNG

Aufgabe der vorliegenden Erfindung ist es daher, eine gattungsgemäße Geräteträgertafel anzugeben, mit der es möglich ist, das gesamte Thermomanagement eines Satelliten zu vereinfachen, und einen Satelliten mit einem solchen vereinfachten Thermomanagement anzugeben.

Der auf die Geräteträgertafel gerichtete Teil der Aufgabe wird gelöst durch die Geräteträgertafel mit den Merkmalen des Patentanspruchs 1.

Diese erfindungsgemäße Geräteträgertafel eines Satelliten mit zumindest einem Elektronikkasten, der elektrische und/oder elektronische Baugruppen aufnimmt, zeichnet sich dadurch aus, dass die Geräteträgertafel eine Grundplatte aufweist, auf der der zumindest eine Elektronikkasten anbringbar ist, und dass die Grundplatte zumindest bereichsweise mittels integrierter Wärmequellen und/oder Wärmesenken temperierbar ausgebildet ist

### VORTEILE

Diese temperierbare Grundplatte der Geräteträgertafel mit integrierten Wärmequellen und/oder Wärmesenken ermöglicht es, bedarfsgerecht sowohl Wärme zuzuführen als auch Wärme abzuführen. Durch die Integration von als Wärmequellen und/oder Wärmesenken arbeitenden Komponenten kann die temperierbare Grundplatte vorgefertigt werden und muss bei der Integration des Satelliten nur noch entsprechend zentral angeschlossen werden, ohne dass es dabei erforderlich ist, jede einzelne an, in oder auf der Grundplatte vorgesehene, als Wärmequelle und/oder Wärmesenke arbeitende Komponente individuell an die Infrastruktur des Satelliten anzuschließen. Der Integrationsaufwand bei der Satellitenfertigung ist daher gegenüber der herkömmlichen Vorgehensweise deutlich reduziert.

Die thermischen Anbindungen einer Geräteträgertafel an die Satelliteninfrastruktur, auch "Thermalharness" genannt, welche konventionell pro Geräteträgertafel ca.40 bis 80 elektrische Leitungen umfassen, müssen nun nicht mehr durch den gesamten Satelliten zur Stromversorgungseinheit PCDU (Power Control and Distribution Unit) und zur ausgelagerten Schnittstelleneinheit RIU (Remote Interface Unit) verlegt werden. Es sind pro Geräteträgertafel statt bislang 40 bis 80 elektrische Leitungen nun nur noch nur noch 4 bis 8 elektrische Leitungen zu verlegen.

Weitere bevorzugte und vorteilhafte Ausgestaltungsmerkmale der erfindungsgemäßen Geräteträgertafel sind Gegenstand der Unteransprüche 2 bis 12. Vorzugsweise ist die Grundplatte zumindest bereichsweise mit Wärmeleiteinrichtungen ausgestattet, die ausgestaltet sind, um auf die Grundplatte oder auf einen Bereich der Grundplatte einwirkende Wärme oder Kälte durch Wärmeleitung abzutransportieren.

Dabei ist es von Vorteil, wenn die Wärmeleiteinrichtungen Heatpipes aufweisen, die an oder in der Grundplatte vorgesehen sind.

Vorteilhafterweise sind die Heatpipes von im Inneren der Grundplatte verlaufenden Bahnen aus einem wärmeleitenden Material gebildet, vorzugsweise aus einem Metall.

Alternativ können die Heatpipes von im Inneren der Grundplatte verlaufenden Kanälen aus einem wärmeleitenden Material, vorzugsweise aus einem Metall, gebildet sein, die von einem Wärmetransportmedium durchströmt sind.

In einer bevorzugten Weiterbildung ist die Grundplatte mit Wärmeleit-Kupplungseinrichtungen versehen ist, die mit den Wärmeleiteinrichtungen in wärmeleitender Verbindung stehen und die mit anderen Wärmeleiteinrichtungen außerhalb der Grundplatte wärmeleitend kuppelbar sind.

Vorteilhaft ist es auch, wenn die Grundplatte zumindest bereichsweise mit elektrischen Kühl- und/oder Heizeinrichtungen ausgestattet ist, die ausgebildet sind, um die Grundplatte oder einen Bereich der Grundplatte unmittelbar zu kühlen oder zu erwärmen. Dabei sind bevorzugterweise als Heizeinrichtungen Widerstandsheizelemente oder alternativ Peltier-Elemente als kombinierte Kühl- und Heizeinrichtungen vorgesehen sind. Erfindungsgemäß ist eine Mehrzahl von individuell ansteuerbaren Wärmeleiteinrichtungen und/oder Kühl- und/oder Heizeinrichtungen über die Fläche der Grundplatte verteilt vorgesehen. Damit ist es möglich, gezielt lokal zu temperieren.

Ist jeder der individuell ansteuerbaren Wärmeleiteinrichtungen und/oder Kühl- und/oder Heizeinrichtungen zumindest ein Temperatursensor in oder auf der Grundplatte zugeordnet, so ist es möglich, die Temperaturverteilung auf der Grundplatte genau zu bestimmen und in der Folge die Temperierung der Grundplatte lokal zu steuern, wozu bevorzugt eine Temperatursteuerungseinrichtung vorgesehen ist, die mit den Temperatursensoren über Signalleitungen verbunden ist und die über Steuerleitungen mit den individuell ansteuerbaren Wärmeleiteinrichtungen und/oder Kühl- und/oder Heizeinrichtungen verbunden ist.

Besonders vorteilhaft ist es, wenn die Temperatursteuerungseinrichtung auf der Grundplatte oder in die Grundplatte integriert vorgesehen ist. Das senkt beträchtlich den Verdrahtungsaufwand beim Einbau der Geräteträgertafel in den Satelliten und auch den damit einhergehenden Testaufwand bei der Integration des Satelliten.

Die Erfindung ist auch gerichtet auf einen Satelliten, der mit einer Mehrzahl von gleichartigen oder unterschiedlichen, erfindungsgemäß ausgebildeten Geräteträgertafeln ausgerüstet ist.

Dabei ist es von Vorteil, wenn die Wärmeleiteinrichtungen der mit zumindest einer Wärmeleiteinrichtung ausgestatteten Grundplatten zumindest teilweise miteinander und/oder mit zumindest einer zentralen Wärmemanagement-Einrichtung des Satelliten in wärmeleitender Verbindung stehen.

Bei einer vorteilhaften Anwendung ist der Satellit mit zumindest einer Dockingstruktur und mit einer Mehrzahl von Elektronikkästen versehen, wobei die Elektronikkästen untereinander elektrisch verbunden oder verbindbar sind und dass die Geräteträgertafel mit der Dockingstruktur verbunden oder verbindbar ist.

Bevorzugte Ausführungsbeispiele der Erfindung mit zusätzlichen Ausgestaltungsdetails und weiteren Vorteilen sind nachfolgend unter Bezugnahme auf die beigefügten Zeichnungen näher beschrieben und erläutert.

### KURZE BESCHREIBUNG DER ZEICHNUNGEN

Es zeigt:
- Fig. 1: eine perspektivische Ansicht einer Grundplatte einer erfindungsgemäßen Geräteträgertafel mit Wärmeleiteinrichtungen und
- Fig. 2: eine perspektivische Ansicht einer Grundplatte einer erfindungsgemäßen Geräteträgertafel mit elektrischen Heizeinrichtungen.

### DARSTELLUNG VON BEVORZUGTEN AUSFÜHRUNGSBEISPIELEN

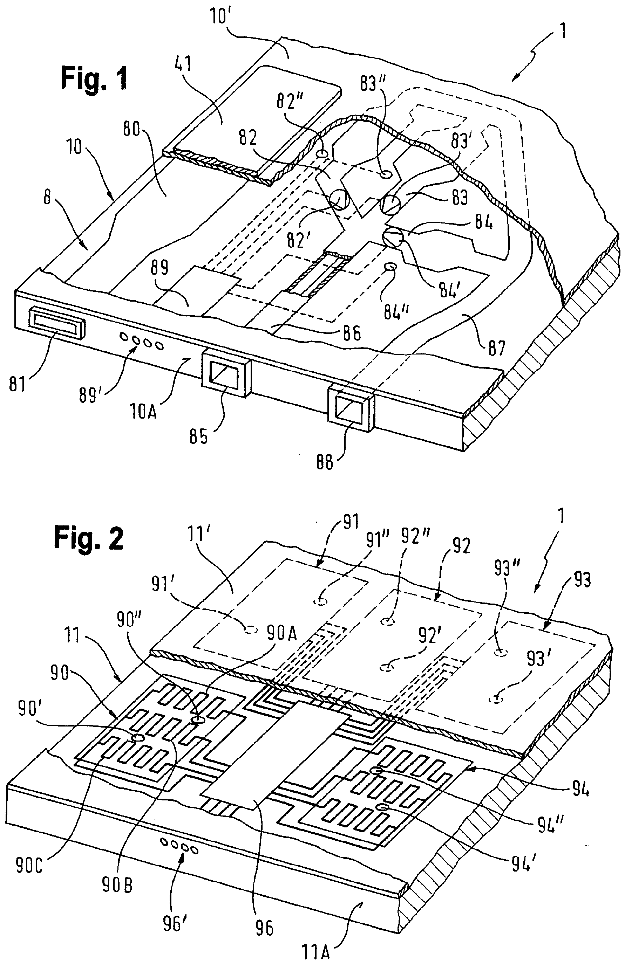

Fig. 1 zeigt in perspektivischer Ansicht eine teilweise aufgeschnittene erfindungsgemäße Geräteträgertafel 1 in einer ersten Ausführungsform. Diese Geräteträgertafel 1 umfasst eine Grundplatte 10, in die Wärmeleiteinrichtungen 8 integriert sind. Die Wärmeleiteinrichtungen 8 sind im gezeigten Beispiel der Fig. 1 in zwei unterschiedlichen Varianten dargestellt.

Eine erste Variante der Wärmeleiteinrichtungen weist eine im Inneren der Grundplatte 10 vorgesehene Wärmeleitschicht 80 aus einem gut wärmeleitenden Material, zum Beispiel einem Metall wie Kupfer oder Aluminium, auf und bildet eine passive Wärmeleiteinrichtung. Auf ihrer Oberseite ist die Grundplatte 10 mit einer gut wärmeleitenden Deckschicht 10' versehen, die in direkter, wärmeübertragender Verbindung mit der Wärmeleitschicht 80 steht. Zusätzlich ist lokal oberhalb der Wärmeleitschicht 80 eine thermische Kontaktplatte 41 angeordnet, die mit der Wärmeleitschicht 80 entweder unmittelbar oder mittelbar über die Deckschicht 10' in wärmeleitender Verbindung steht. Auf der thermischen Kontaktplatte 41 können Komponenten (zum Beispiel Elektronikkästen) platziert werden, die Wärme erzeugen, die abgeführt werden muss.

Die Wärmeleitschicht 80 mündet in einer Stirnseite 10A der Grundplatte 10 in eine erste Wärmeleit-Kupplungseinrichtung 81, über die beim Einbau der Geräteträgertafel 1 in eine Satelliten-Infrastruktur eine Wärmeleitverbindung zu einem nicht näher gezeigten Wärmeleitkanal der Satelliten-Infrastruktur herstellbar ist. Auf diese Weise kann die von den Komponenten der Geräteträgerplatte 1 in die Grundplatte 10 eingeleitete Wärme zu an den Wärmeleitkanal angeschlossenen Wärmesenken abgeleitet werden. Derartige Wärmesenken können beispielsweise Grundplatten von anderen Geräteträgertafeln sein, die sich auf der Schattenseite des Satelliten befinden.

In Fig. 1 ist noch eine zweite Variante der Wärmeleiteinrichtungen 8 dargestellt, die aktiv arbeitet. Dazu ist im Inneren der Grundplatte ein System von Kanälen 82, 83, 84 aus einem gut wärmeleitenden Material, zum Beispiel einem Metall, wie beispielsweise Kupfer oder Aluminium, vorgesehen. Die Kanäle 82, 83, 84, die in ihrer Breitenabmessung variieren können, wie in Fig. 1 zu erkennen ist, sind hohl und werden von einem Wärmetransportfluid durchströmt. Eine zweite Wärmeleit-Kupplungseinrichtung 85 ist in der Stirnseite 10A der Grundplatte 10 vorgesehen und ein Zulaufkanal 86 verläuft von dort im Inneren der Grundplatte 10 zu den Kanälen 82, 83, 84. Steuerbare Ventile 82', 83', 84' sind jeweils im zugeordneten Kanal 82, 83, 84 angeordnet, um den Durchfluss des Wärmetransportfluids zu steuern. Die Kanäle 82, 83, 84 münden hinter den Ventilen 82', 83', 84' in einen gemeinsamen Rücklaufkanal 87, der zu einer dritten, in der Stirnseite 10A der Grundplatte 10 vorgesehenen Wärmeleit-Kupplungseinrichtung 88 verläuft. Auch wenn das in Fig. 1 nicht explizit dargestellt ist, kann auch bei dieser Variante zumindest eine thermische Kontaktplatte 41 in derselben Weise wie die in Verbindung mit der ersten Variante beschrieben worden ist, vorgesehen sein.

Dem jeweiligen Kanal 82, 83, 84 ist jeweils zumindest ein Temperatursensor 82", 83", 84" zugeordnet. Die Temperatursensoren 82", 83", 84" und auch die steuerbaren Ventile 82', 83', 84' stehen über gestrichelt gezeichnete Signalleitungen mit einer Temperatursteuerungseinrichtung 89 in elektrisch leitender Verbindung. Die Temperatursteuerungseinrichtung 89 ist im gezeigten Beispiel als in das Innere der Grundplatte 10 integrierte Komponente dargestellt, sie kann aber auch anderweitig an oder auf der Grundplatte 10 vorgesehen sein und ist auf jeden Fall Bestandteil der die Grundplatte 10 aufweisenden Geräteträgertafel 1. Elektrische Kontakteinrichtungen 89' sind in der Stirnseite 10A der Grundplatte 10 vorgesehen und dienen im in einen Satelliten eingebauten Zustand dazu, elektrische Verbindungen zu einer Stromversorgungseinheit und zu einer zentralen Kontrolleinrichtung des Satelliten herzustellen.

Obwohl in Fig. 1 zwei unterschiedliche Varianten der Wärmeleiteinrichtungen 8 dargestellt sind, ist es für den Fachmann klar, dass er in einer Grundplatte 10 ausschließlich die erste, passive Variante oder ausschließlich die zweite, aktive Variante vorsehen kann. Selbstverständlich ist es aber auch möglich, die beiden Varianten in beliebiger Weise unabhängig nebeneinander (wie in Fig. 1 gezeigt) oder miteinander kombiniert in einer Grundplatte vorzusehen.

Fig. 2 zeigt eine zweite Ausführungsform einer Grundplatte 11 der erfindungsgemäßen Geräteträgertafel 1, wobei die Grundplatte 11 mit einer Mehrzahl von elektrischen Heizeinrichtungen 90, 91, 92, 93, 94 zu versehen. Die elektrischen Heizeinrichtungen 90, 91, 92, 93, 94 können, wie in Fig. 2 dargestellt ist, im Inneren der Grundplatte 11 vorgesehen und von einer gut wärmeleitenden Deckschicht 11' abgedeckt sein, die in direkter, wärmeübertragender Verbindung mit den elektrischen Heizeinrichtungen 90, 91, 92, 93, 94 steht. Die elektrischen Heizeinrichtungen 90, 91, 92, 93, 94 können von Folienheizelementen gebildet sein und jeweils zumindest einen Temperatursensor 90', 90", 91', 91", 92', 92", 93', 93", 94', 94" aufweisen. Wie in Fig 2 gezeigt ist, kann jede der elektrischen Heizeinrichtungen 90, 91, 92, 93, 94 getrennt voneinander ansteuerbare Heizbereiche (zum Beispiel 90A, 90B, 90C) aufweisen. Jeder Heizbereich einer jeden Heizeinrichtung 90, 91, 92, 93, 94 steht über eine eigene Stromversorgungsleitung (in Fig. 2 gestrichelt gezeichnet) mit einer in, an oder auf der Grundplatte 11 vorgesehenen Temperatursteuerungseinrichtung 96 in elektrisch leitender Verbindung. Auch die jeweiligen in oder auf der Grundplatte 11 vorgesehenen Temperatursensoren 90', 90", 91', 91", 92', 92", 93', 93", 94', 94" sind über eine jeweilige Signalleitung (in Fig. 2 gestrichelt gezeichnet) mit der Temperatursteuerungseinrichtung 96 zur Signalübertragung elektrisch leitend verbunden. Die Temperatursteuerungseinrichtung 96 ist so in der Lage, die elektrische Energie, die jedem Heizbereich einer jeden Heizeinrichtung 90, 91, 92, 93, 94 zugeführt wird, unter Berücksichtigung der Signale der Temperatursensoren 90', 90", 91', 91", 92', 92", 93', 93", 94', 94" zu regeln. Über in der Stirnseite 11A der Grundplatte 11 vorgesehene elektrische Kontakte 96' wird die Temperatursteuerungseinrichtung 96 im in den Satelliten eingebauten Zustand der die Grundplatte 11 aufweisenden Geräteträgertafel 1 mit elektrischer Energie versorgt und steht außerdem im Datenaustausch mit einer übergeordneten Thermomanagement-Steuerungseinrichtung des Satelliten.

Die elektrischen Heizeinrichtungen 90, 91, 92, 93, 94 sind, vorzugsweise in einem gleichmäßigen Raster, über die Fläche der Grundplatte 11 oder zumindest über einen Bereich der Fläche der Grundplatte 11 verteilt angeordnet. Dadurch ist es möglich, die Grundplatte lokal unterschiedlich intensiv und lokal temperaturgeregelt zu heizen.

Auch wenn die beschriebenen Ausführungsformen der Fig. 1 und 2 in den Figuren separat dargestellt ist, können die Ausführungsformen der Fig. 1 und 2 beliebig miteinander kombiniert werden. Ebenso kann auch bei dieser Ausführungsform mit elektrischen Heiz-/Kühleinrichtungen zumindest eine thermische Kontaktplatte 41 in derselben Weise wie die in Verbindung mit der ersten Ausführungsform beschrieben worden ist, vorgesehen sein.

Die in Fig.2 dargestellte Ausführungsform betrifft weiterhin auch Satelliten mit Geräteträgertafeln, welche auf konventionelle Weise ohne die beschriebene Dockingstruktur ausgerüstet sind, sondern mit herkömmlichen Schraubverbindungen zur Befestigung der Elektronikkästen und mit herkömmlichen Kabelbäumen und manuell zu steckenden Steckverbindungen zur elektrischen Verbindung der Elektronikkästen ausgerüstet sind.

Die elektrischen Heizeinrichtungen 90, 91, 92, 93, 94 können beispielsweise auch die Größe der gesamten Grundplatte 11 aufweisen.

Vorzugsweise wird jede Geräteträgertafel mit derselben Ausstattung ausgerüstet. Hierdurch ist eine zeitgünstige, effiziente und kostengünstige, Serienfertigung möglich. Auch bietet das eine Gewähr für eine Satellitenstrukturfertigung mit einer sehr geringen Fehlerquote. Die Definition und Anordnung der Elemente, wie zum Beispiel Heizung, Temperatursensoren usw., erfolgt durch ein neu für einen Satelliten zu erstellendes Standard-Thermalmodell des jeweiligen Satelliten.

In die Struktur der erfindungsgemäßen Thermo-Grundplatten 11 können, wie in Fig. 1 gezeigt ist, auch "Heat-Pipes" (aktiv oder passiv) eingebaut werden, damit aus der so standardisierten Grundplatte auch Wärme abgeführt werden kann. Passive Heat-Pipes bilden ein Wämeableitsystem durch Wärme-Konvektion in Verbindung mit festen und/oder flüssigen Medien. Aktive Heat-Pipes bilden ein Wärmeableitsystem durch Wärme-Konvektion in Verbindung mit festen und flüssigen Medien in weiterer Verbindung mit einem Kühlsystem, mit zum Beispiel Peltier-Elementen, Mikrokompressoren, Sterlingmotor oder Ähnlichem.

Bei Heat-Pipes, die mit Aktuatoren ausgestattet sind (zum Beispiel Drosseln, Ventilen, Pumpen, Motoren, Spulen, Peltier-Elementen), werden diese Aktuatoren über eine in die Grundplatte eingebettete, zum Beispiel von einem Microcontroller gesteuerte Steuerelektronik (Temperatursteuerungseinrichtung 96), die zum Beispiel wie ein Arduino-Computer arbeitet, aktiviert. Jegliche Heat-Pipe-spezifische Sensorik wird auch über diese zum Beispiel von einem Microcontroller gesteuerte Steuerelektronik ausgelesen und verarbeitet.

Die Kommandierung dieser Aktuator-Elemente und die Erfassung der Daten aller Sensorelemente, welche im Panel eingebettet oder am Panel angebracht sind, sowie aller anderen in oder auf der Grundplatte vorgesehenen Elemente des Thermomanagements erfolgt über die in der oder auf der Grundplatte vorgesehene Steuerelektronik. Die Steuerelektronik kann die Thermalregelung selbst durchführen oder über eine bi-direktionale, digitale Bus-Steuerung von einer Steuereinheit kommandiert werden, welche eine dem projektbezogenen Thermalkonzept zugrunde liegende, in Software abgebildete Regelung beinhaltet. Die Thermal-Kontrolle oder Thermal-Regelung der Grundplatte und damit auch der Geräteträgertafel erfolgt über die in der oder auf der Grundplatte vorgesehene Steuerelektronik (Microcontroller), welche selbst die Steuerung übernehmen kann oder über eine übergeordnete Steuereinheit Kommandos erhält.

Bezugszeichen in den Ansprüchen, der Beschreibung und den Zeichnungen dienen lediglich dem besseren Verständnis der Erfindung und sollen den Schutzumfang nicht einschränken. Die einzelnen Merkmale der gezeigten, beschriebenen und in den Ansprüchen beanspruchten Varianten und Weiterbildungen der Erfindung können im Rahmen der Erfindung beliebig miteinander kombiniert werden.

### Bezugszeichenliste

Es bezeichnen:
- 1: Geräteträgertafel
- 8: Wärmeleiteinrichtungen
- 10: Grundplatte
- 10': Deckschicht
- 10A: Stirnseite der Grundplatte
- 11: Grundplatte
- 11': Deckschicht
- 11A: Stirnseite der Grundplatte
- 41: Kontaktplatte
- 80: Wärmeleitschicht
- 81: Wärmeleit-Kupplungseinrichtung
- 82: Kanäle
- 82': steuerbares Ventil
- 82": Temperatursensor
- 83: Kanäle
- 83': steuerbares Ventil
- 83": Temperatursensor
- 84: Kanäle
- 84': steuerbares Ventil
- 84": Temperatursensor
- 85: Wärmeleit-Kupplungseinrichtung
- 86: Zulaufkanal
- 87: Rücklaufkanal
- 88: Wärmeleit-Kupplungseinrichtung
- 89: Temperatursteuerungseinrichtung
- 89': elektrische Kontakteinrichtung
- 90: elektrische Heizeinrichtung
- 90': Temperatursensor
- 90": Temperatursensor
- 91: elektrische Heizeinrichtung
- 91': Temperatursensor
- 91": Temperatursensor
- 92: elektrische Heizeinrichtung
- 92': Temperatursensor
- 92": Temperatursensor
- 93: elektrische Heizeinrichtung
- 93': Temperatursensor
- 93": Temperatursensor
- 94: elektrische Heizeinrichtung
- 94': Temperatursensor
- 94": Temperatursensor
- 96: Temperatursteuerungseinrichtung
- 96': elektrische Kontakte

## Patentansprüche

1. Geräteträgertafel eines Satelliten mit zumindest einem Elektronikkasten (3), der elektrische und/oder elektronische Baugruppen aufnimmt,
- wobei die Geräteträgertafel (1) eine Grundplatte (10; 11) aufweist, auf der der zumindest eine Elektronikkasten (3) anbringbar ist, und
- wobei die Grundplatte (10; 11) zumindest bereichsweise mittels integrierter Wärmequellen und/oder Wärmesenken temperierbar ausgebildet ist **dadurch gekennzeichnet,**
- **dass** eine Mehrzahl von individuell ansteuerbaren Wärmeleiteinrichtungen (82, 83, 84) und/oder Kühl- und/oder Heizeinrichtungen (90, 91, 92, 93, 94) über die Fläche der Grundplatte (10; 11) verteilt vorgesehen ist.

2. Geräteträgertafel nach Anspruch 1,
**dadurch gekennzeichnet,**
**dass** die Grundplatte (10) zumindest bereichsweise mit Wärmeleiteinrichtungen (8) ausgestattet ist, die ausgestaltet sind, um auf die Grundplatte (10) oder auf einen Bereich der Grundplatte (10) einwirkende Wärme oder Kälte durch Wärmeleitung abzutransportieren.

3. Geräteträgertafel nach Anspruch 2,
**dadurch gekennzeichnet,**
**dass** die Wärmeleiteinrichtungen (8) Heatpipes (80; 82, 83, 84, 86, 87) aufweisen, die an oder in der Grundplatte (10) vorgesehen sind.

4. Geräteträgertafel nach Anspruch 3,
**dadurch gekennzeichnet,**
**dass** die Heatpipes (80) gebildet sind von im Inneren der Grundplatte (10) verlaufenden Bahnen aus einem wärmeleitenden Material, vorzugsweise aus einem Metall.

5. Geräteträgertafel nach Anspruch 3,
**dadurch gekennzeichnet,**
**dass** die Heatpipes (82, 83, 84, 86, 87) gebildet sind von im Inneren der Grundplatte (10) verlaufenden Kanälen aus einem wärmeleitenden Material, vorzugsweise aus einem Metall, die von einem Wärmetransportmedium durchströmt oder durchströmbar sind.

6. Geräteträgertafel nach einem der Ansprüche 2 bis 5,
**dadurch gekennzeichnet,**
**dass** die Grundplatte (10) mit Wärmeleit-Kupplungseinrichtungen (81; 85, 88) versehen ist, die mit den Wärmeleiteinrichtungen (8) in wärmeleitender Verbindung stehen und die mit anderen Wärmeleiteinrichtungen außerhalb der Grundplatte (10) wärmeleitend kuppelbar sind.

7. Geräteträgertafel nach einem der vorhergehenden Ansprüche,
**dadurch gekennzeichnet,**
**dass** die Grundplatte (11) zumindest bereichsweise mit elektrischen Kühl- und/oder Heizeinrichtungen (90, 91, 92, 93, 94) ausgestattet ist, die ausgebildet sind, um die Grundplatte (11) oder einen Bereich der Grundplatte (11) unmittelbar zu kühlen oder zu erwärmen.

8. Geräteträgertafel nach Anspruch 7,
**dadurch gekennzeichnet,**
**dass** als Heizeinrichtungen (90, 91, 92, 93, 94) Widerstandsheizelemente vorgesehen sind.

9. Geräteträgertafel nach Anspruch 7,
**dadurch gekennzeichnet,**
**dass** als kombinierte Kühl- und Heizeinrichtungen Peltier-Elemente vorgesehen sind.

10. Geräteträgertafel nach Anspruch 1,
**dadurch gekennzeichnet,**
**dass** jeder der individuell ansteuerbaren Wärmeleiteinrichtungen (82, 83, 84) und/oder Kühl- und/oder Heizeinrichtungen (90, 91, 92, 93, 94) zumindest ein Temperatursensor (82", 83", 84"; 90', 90", 91', 91", 92', 92", 93', 93", 94', 94") in oder auf der Grundplatte (10; 11) zugeordnet ist.

11. Geräteträgertafel nach Anspruch 10,
**dadurch gekennzeichnet,**
**dass** eine Temperatursteuerungseinrichtung (89; 96) vorgesehen ist, die mit den Temperatursensoren (82", 83", 84"; 90', 90", 91', 91", 92', 92", 93', 93", 94', 94") über Signalleitungen verbunden ist und die über Steuerleitungen mit den individuell ansteuerbaren Wärmeleiteinrichtungen (82, 83, 84) und/oder Kühl- und/oder Heizeinrichtungen (90, 91, 92, 93, 94) verbunden ist.

12. Geräteträgertafel nach Anspruch 11,
**dadurch gekennzeichnet,**
**dass** die Temperatursteuerungseinrichtung (89; 96) auf der Grundplatte (10; 11) oder in die Grundplatte (10; 11) integriert vorgesehen ist.

13. Satellit ausgerüstet mit einer Mehrzahl von gleichartigen oder unterschiedlichen Geräteträgertafeln (1) nach einem oder mehreren der vorhergehenden Ansprüche.

14. Satellit nach Anspruch 13
**dadurch gekennzeichnet,**
**dass** die Wärmeleiteinrichtungen der mit zumindest einer Wärmeleiteinrichtung ausgestatteten Grundplatten zumindest teilweise miteinander und/oder mit zumindest einer zentralen Wärmemanagement-Einrichtung des Satelliten in wärmeleitender Verbindung stehen.

15. Satellit nach Anspruch 13 oder 14,
**dadurch gekennzeichnet,**
**dass** der Satellit mit zumindest einer Dockingstruktur (2) und mit einer Mehrzahl von Elektronikkästen (3) versehen ist, wobei die Elektronikkästen (3) untereinander elektrisch verbunden oder verbindbar sind und dass die Geräteträgertafel (1) mit der Dockingstruktur (2) verbunden oder verbindbar ist.

## Claims

1. A device carrier panel of a satellite, having at least one electronic box (3) that accommodates electrical and/or electronic modules,
- the device carrier panel (1) having a base plate (10; 11) on which the at least one electronic box (3) is mountable, and
- the base plate (10; 11) having, at least in areas, a design that is temperature-controllable by means of integrated heat sources and/or heat sinks,
**characterized in that**
- a plurality of individually controllable heat-conducting devices (82, 83, 84) and/or cooling and/or heating devices (90, 91, 92, 93, 94) is provided distributed over the surface of the base plate (10; 11).

2. The device carrier panel according to Claim 1,
**characterized in that**
the base plate (10) is equipped, at least in areas, with heat-conducting devices (8) that are designed for removing, via heat conduction, heat or cold acting on the base plate (10) or on an area of the base plate (10).

3. The device carrier panel according to Claim 2,
**characterized in that**
the heat-conducting devices (8) have heat pipes (80; 82, 83, 84, 86, 87) that are provided on or in the base plate (10).

4. The device carrier panel according to Claim 3,
**characterized in that**
the heat pipes (80) are formed from tracks made of a heat-conducting material, preferably a metal, that extend in the interior of the base plate (10).

5. The device carrier panel according to Claim 3,
**characterized in that**
the heat pipes (82, 83, 84, 86, 87) are formed from channels made of a heat-conducting material, preferably a metal, that extend in the interior of the base plate (10), and through which a heat transport medium flows or may flow.

6. The device carrier panel according to one of Claims 2 to 5,
**characterized in that** the base plate (10) is provided with heat conduction coupling devices (81; 85, 88) which are in heat-conducting connection with the heat-conducting devices (8), and which may be heat-conductively coupled to other heat-conducting devices outside the base plate (10).

7. The device carrier panel according to one of the preceding claims,
**characterized in that**
the base plate (11) is equipped, at least in areas, with electrical cooling and/or heating devices (90, 91, 92, 93, 94) that are designed for directly cooling or heating the base plate (11) or an area of the base plate (11).

8. The device carrier panel according to Claim 7,
**characterized in that**
resistance heating elements are provided as heating devices (90, 91, 92, 93, 94).

9. The device carrier panel according to Claim 7,
**characterized in that**
Peltier elements are provided as combined cooling and heating devices.

10. The device carrier panel according to Claim 1,
**characterized in that**
at least one temperature sensor (82", 83", 84"; 90', 90", 91', 91", 92', 92", 93', 93", 94', 94") in or on the base plate (10; 11) is associated with each of the individually controllable heat-conducting devices (82, 83, 84) and/or cooling and/or heating devices (90, 91, 92, 93, 94).

11. The device carrier panel according to Claim 10,
**characterized in that**
a temperature control device (89; 96) is provided which is connected to the temperature sensors (82", 83", 84"; 90', 90", 91', 91", 92', 92", 93', 93", 94', 94") via signal lines, and which is connected to the individually controllable heat-conducting devices (82, 83, 84) and/or cooling and/or heating devices (90, 91, 92, 93, 94) via control lines.

12. The device carrier panel according to Claim 11,
**characterized in that**
the temperature control device (89; 96) is provided on the base plate (10; 11) or is integrated into the base plate (10; 11).

13. A satellite equipped with a plurality of identical or different device carrier panels (1) according to one or more of the preceding claims.

14. The satellite according to Claim 13,
**characterized in that**
the heat-conducting devices of the base plates equipped with at least one heat-conducting device are at least in partial heat-conducting connection with one another and/or with at least one central heat management device of the satellite.

15. The satellite according to Claim 13 or 14,
**characterized in that**
the satellite is provided with at least one docking structure (2) and with a plurality of electronic boxes (3), the electronic boxes (3) being electrically connected or connectable to one another, and the device carrier panel (1) is connected or connectable to the docking structure (2).

## Revendications

1. Panneau porte-appareillages d'un satellite avec au moins un boîtier électronique (3) logeant des sous-ensembles électriques et/ou électroniques,
- dans lequel le panneau porte-appareillages (1) présente un châssis (10 ; 11) sur lequel peut être placé ledit au moins un boîtier électronique (3), et
- dans lequel le châssis (10 ; 11) est réalisé de manière à pouvoir être tempéré au moins localement au moyen de sources de chaleur et/ou de puits de chaleur intégrés,
**caractérisé en ce qu'**une pluralité de dispositifs thermoconducteurs (82, 83, 84) et/ou de dispositifs réfrigérants et/ou chauffants (90, 91, 92, 93, 94) à commande individuelle est prévue de manière répartie sur la surface du châssis (10 ; 11).

2. Panneau porte-appareillages selon la revendication 1, **caractérisé en ce que** le châssis (10) est équipé au moins localement de dispositifs thermoconducteurs (8) configurés pour évacuer par thermoconduction la chaleur ou le froid agissant sur le châssis (10) ou sur une zone du châssis (10).

3. Panneau porte-appareillages selon la revendication 2, **caractérisé en ce que** les dispositifs thermoconducteurs (8) présentent des caloducs (80 ; 82, 83, 84, 86, 87) prévus sur ou dans le châssis (10).

4. Panneau porte-appareillages selon la revendication 3, **caractérisé en ce que** les caloducs (80) sont formés par des pistes en matériau thermoconducteur, de préférence en métal, s'étendant à l'intérieur du châssis (10).

5. Panneau porte-appareillages selon la revendication 3, **caractérisé en ce que** les caloducs (82, 83, 84, 86, 87) sont formés par des canaux en matériau thermoconducteur, de préférence en métal, s'étendant à l'intérieur du châssis et dans lesquels coulent ou peut couler un milieu caloporteur.

6. Panneau porte-appareillages selon l'une quelconque des revendications 2 à 5, **caractérisé en ce que** le châssis (10) est muni de dispositifs de couplage thermique (81 ; 85, 88) en communication thermoconductrice avec les dispositifs thermoconducteurs (8) et qui peuvent être accouplés de manière thermoconductrice aux autres dispositifs thermoconducteurs en dehors du châssis (10).

7. Panneau porte-appareillages selon l'une quelconque des revendications précédentes, **caractérisé en ce que** le châssis (11) est muni au moins localement de dispositifs électriques réfrigérants et/ou chauffants (90, 91, 92, 93, 94) qui sont réalisés pour refroidir ou chauffer directement le châssis (11) ou une zone du châssis (11).

8. Panneau porte-appareillages selon la revendication 7, **caractérisé en ce que** des éléments chauffants résistifs sont prévus comme dispositifs chauffants (90, 91, 92, 93, 94).

9. Panneau porte-appareillages selon la revendication 7, **caractérisé en ce que** des éléments Peltier sont prévus comme dispositifs réfrigérants et chauffants combinés.

10. Panneau porte-appareillages selon la revendication 1, **caractérisé en ce qu'**à chacun des dispositifs thermoconducteurs (82, 83, 84) à commande individuelle et/ou des dispositifs réfrigérants et/ou chauffants (90, 91, 92, 93, 94) est attribué au moins un capteur de température (82", 83", 84" ; 90', 90", 91', 91", 92', 92", 93', 93", 94', 94") dans ou sur le châssis (10 ; 11).

11. Panneau porte-appareillages selon la revendication 10, **caractérisé en ce qu'**un dispositif de régulation de température (89 ; 96) est prévu qui est relié aux capteurs de température (82", 83", 84" ; 90', 90", 91', 91", 92', 92", 93', 93", 94', 94") par des lignes de signalisation et qui est relié aux dispositifs thermoconducteurs (82, 83, 84) et/ou aux dispositifs réfrigérants et/ou chauffants (90, 91, 92, 93, 94) à commande individuelle par des lignes de commande.

12. Panneau porte-appareillages selon la revendication 11, **caractérisé en ce que** le dispositif de régulation de température (89 ; 96) est prévu de manière intégrée sur le châssis (10 ; 11) ou dans le châssis (10 ; 11).

13. Satellite, équipé d'une pluralité de panneaux porte-appareillages (1) de type identique ou différent selon une ou plusieurs des revendications précédentes.

14. Satellite selon la revendication 13, **caractérisé en ce que** les dispositifs thermoconducteurs des châssis équipés d'au moins un dispositif thermoconducteur sont au moins partiellement en communication thermoconductrice entre elles et/ou avec au moins un dispositif de gestion de chaleur central du satellite.

15. Satellite selon la revendication 13 ou 14, **caractérisé en ce que** le satellite est muni d'au moins une structure d'amarrage (2) et d'une pluralité de boîtiers électroniques (3), lesdits boîtiers électroniques (3) étant reliés ou susceptibles d'être reliés électriquement entre eux et **en ce que** le panneau porte-appareillages (1) est relié ou susceptible d'être relié à la structure d'amarrage (2).
